(19) **Europäisches Patentamt / European Patent Office / Office européen des brevets**

(11) **EP 4 341 703 B1**

(12) **EUROPÄISCHE PATENTSCHRIFT**

(45) Veröffentlichungstag und Bekanntmachung des Hinweises auf die Patenterteilung:
**08.07.2026   Patentblatt 2026/28**

(21) Anmeldenummer: **22728881.8**

(22) Anmeldetag: **12.05.2022**

(51) Internationale Patentklassifikation (IPC):
**G01R 27/14** $^{(2006.01)}$     **G01R 31/34** $^{(2020.01)}$

(52) Gemeinsame Patentklassifikation (CPC):
**G01R 27/14; G01R 31/343; G01R 31/346**

(86) Internationale Anmeldenummer:
**PCT/EP2022/062966**

(87) Internationale Veröffentlichungsnummer:
**WO 2022/243176 (24.11.2022 Gazette 2022/47)**

(54) **VERFAHREN UND VORRICHTUNG ZUM BESTIMMEN EINES STRANGWIDERSTANDES EINER ELEKTRISCHEN MASCHINE**

METHOD AND DEVICE FOR DETERMINING A PHASE RESISTANCE OF AN ELECTRIC MACHINE

PROCÉDÉ ET DISPOSITIF POUR DÉTERMINER UNE RÉSISTANCE DE PHASE D'UNE MACHINE ÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **19.05.2021   DE 102021205115**

(43) Veröffentlichungstag der Anmeldung:
**27.03.2024   Patentblatt 2024/13**

(73) Patentinhaber: **VOLKSWAGEN AKTIENGESELLSCHAFT
38440 Wolfsburg (DE)**

(72) Erfinder: **WEBER, Bastian
30161 Hannover (DE)**

(56) Entgegenhaltungen:
**US-A1- 2021 021 221**

- **WEBER BASTIAN ET AL: "Compensation of switching dead-time effects in voltage-fed PWM inverters using FPGA-based current oversampling", 2016 IEEE APPLIED POWER ELECTRONICS CONFERENCE AND EXPOSITION (APEC), IEEE, 20 March 2016 (2016-03-20), pages 3172 - 3179, XP032899230, ISBN: 978-1-4673-8393-6, [retrieved on 20160510], DOI: 10.1109/APEC.2016.7468318**

## Beschreibung

Die Erfindung betrifft ein Verfahren und eine Vorrichtung zum Bestimmen eines Strangwiderstandes einer elektrischen Maschine.

Im Gegensatz zu Verbrennungskraftmaschinen zeichnen sich elektrische Antriebssysteme durch einen deutlich größeren Wirkungsgrad aus, was maßgeblich zum Erfolg der Elektromobilität beiträgt. Eine Kenntnis der Betriebseigenschaften, insbesondere eines Strangwiderstands, eines elektrischen Antriebssystems erlaubt Vorhersagen in Bezug auf die Alterung des Systems. Es können aber auch die Betriebsgrenzen des Systems hinsichtlich einer möglichen Dauerleistung sowie einer Überlastfähigkeit höher ausgelastet werden. Im Ergebnis resultieren daraus für die Traktionseigenschaften von elektrifizierten Fahrzeugen entscheidende Vorteile.

Aus der DE 10 2017 117 725 A1 sind ein System und ein Verfahren zum Bestimmen mindestens eines Parameters eines Motors, wie zum Beispiel einer Induktivität, bekannt. Die Induktivität kann zum Beispiel auf der Basis von einem oder mehreren digital abgetasteten Motorwicklungsströmen bestimmt werden. Ein digitales Filter kann auf die digitalen Abtastwerte angewendet werden, zum Beispiel um eine Steigung der Motorwicklungsströme zu bestimmen. Das digitale Filter kann eine Anpassung kleinster Quadrate umfassen, die auf die digitalen Abtastwerte angewendet werden kann, zum Beispiel um eine Steigung der Motorwicklungsströme zu bestimmen. Die Anpassung kleinster Quadrate kann auf der Basis einer Berechnung von zentralen Tendenzen bestimmt werden, wie zum Beispiel eines Mittelwerts der Zeit, eines Mittelwerts des Stroms, eines Mittelwerts des Quadrats der Zeit und des Mittelwerts des Produkts aus Zeit und Strom. Die Mittelwerte können rekursiv bestimmt werden, um eine verbesserte Rechengeschwindigkeit zu schaffen.

Die US 2021 / 0 021 221 A1 beschreibt Systeme und Verfahren zum Extrahieren von Motorbetriebszustandsparametern aus einem Elektromotor zur verbesserten Motorsteuerung und Motorfehler- oder -ausfallerkennung. Ein beispielhaftes System umfasst eine Erregerschaltung zum Anlegen einer Antriebsspannung an einen Elektromotor und eine Prozessorschaltung zum Messen eines resultierenden Wicklungsstroms, zum Extrahieren einer Stromwellenform durch Überabtasten des Wicklungsstroms in einem gesamten PWM-Frame mit einer Abtastrate, die höher ist als die PWM-Frequenz, und zum Anpassen der Stromwellenform in der PWM-Periode an ein parametrisches Modell. Die Prozessorschaltung kann einen Betriebszustandsparameter des Motors anhand der angelegten Antriebsspannung und/oder des parametrischen Modells des Wicklungsstroms ermitteln.

Aus B. Weber, T. Brandt and A. Mertens, Compensation of switching dead-time effects in voltage-fed PWM inverters using FPGA-based current oversampling, 2016 IEEE Applied Power Electronics Conference and Exposition (APEC), Long Beach, CA, USA, 2016, S. 3172-3179, doi: 10.1109/APEC.2016.7468318, ist ein Verfahren zur Totzeitkompensation bekannt. Aus Bastian Weber, Positionsgeberlose Regelung von permanentmagneterregten Synchronmaschinen bei kleinen Drehzahlen mit überabtastender Stromerfassung, Hannover, Gottfried Wilhelm Leibniz Universität Hannover, Dissertation, 2018, 163 S., https://doi.org/10.15488/9140, ist ein Verfahren zum Schätzen einer Rotorlage und/oder einer Rotordrehzahl bekannt.

Der Erfindung liegt die Aufgabe zu Grunde, ein Verfahren und eine Vorrichtung zum Bestimmen eines Strangwiderstandes einer elektrischen Maschine zu schaffen.

Die Aufgabe wird erfindungsgemäß durch ein Verfahren mit den Merkmalen des Patentanspruchs 1 und eine Vorrichtung mit den Merkmalen des Patentanspruchs 12 gelöst Vorteilhafte Ausgestaltungen der Erfindung ergeben sich aus den Unteransprüchen. Insbesondere wird ein Verfahren zum Bestimmen eines Strangwiderstandes einer elektrischen Maschine zur Verfügung gestellt, wobei Strangströme der elektrischen Maschine hochfrequent erfasst werden, wobei unter Berücksichtigung einer Totzeitkompensation zugehörige Strangspannungen bestimmt werden, wobei eine Rotorlage der elektrischen Maschine erfasst oder geschätzt wird, wobei ein hochfrequentes Testsignal bezüglich der Strangspannungen mittels eines die elektrische Maschine speisenden Pulswechselrichters durch Modulation erzeugt und aufgeprägt wird, wobei mittels eines Beobachters ein ohmsch-induktiver Spannungsanteil einer Systemantwort der elektrischen Maschine auf das aufgeprägte hochfrequente Testsignal bestimmt wird, und wobei ausgehend von dem bestimmten ohmsch-induktiven Spannungsanteil der Strangwiderstand bestimmt und bereitgestellt wird.

Ferner wird insbesondere eine Vorrichtung zum Bestimmen eines Strangwiderstandes einer elektrischen Maschine geschaffen, umfassend eine Steuereinrichtung, wobei die Steuereinrichtung dazu eingerichtet ist, hochfrequent erfasste Strangströme zu empfangen, unter Berücksichtigung einer Totzeitkompensation zugehörige Strangspannungen zu bestimmen, eine erfasste oder geschätzte Rotorlage der elektrischen Maschine zu empfangen, einen die elektrische Maschine speisenden Pulswechselrichter derart anzusteuern, dass dieser durch Modulation ein hochfrequentes Testsignal bezüglich der Strangspannungen erzeugt und aufprägt, mittels eines Beobachters einen ohmsch-induktiven Spannungsanteil einer Systemantwort der elektrischen Maschine auf das aufgeprägte hochfrequente Testsignal zu bestimmen, und ausgehend von dem bestimmten ohmsch-induktiven Spannungsanteil den Strangwiderstand zu bestimmen und bereitzustellen.

Das Verfahren und die Vorrichtung ermöglichen es, einen Strangwiderstand einer elektrischen Maschine, insbesondere eines Elektromotors, aus erfassten Strangströmen, bestimmten Strangspannungen und einer erfassten oder geschätzten Rotorlage zu bestimmen. Die Strangströme werden hochfrequent, das heißt, überabgetastet, erfasst.

Dies bedeutet, dass eine Frequenz der Abtastung deutlich größer ist als eine Modulationsfrequenz eines Pulswechselrichters, der zum Speisen der elektrischen Maschine verwendet wird, insbesondere um einen Faktor 10, 100 oder 1000 größer. Es ist vorgesehen, ein hochfrequentes Testsignal auf die Strangspannungen aufzuprägen, indem der Pulswechselrichter entsprechend angesteuert wird. Dies erfolgt insbesondere in Form eines hochfrequenten (z.B. 3 bis 5 kHz oder darüber) Spannungssignals, das in die d-Achse eingeprägt wird. Eine Dauer des Testsignals beträgt hierbei etwa 1 bis 10 Pulsperioden des Pulswechselrichters. Eine Systemantwort der elektrischen Maschine auf das aufgeprägte Testsignal wird erfasst und ausgewertet. Dies erfolgt insbesondere mit Hilfe der Stator-Spannungsdifferentialgleichungen im statorfesten Koordinatensystem, in die die erfassten (bzw. geschätzten) und die bestimmten Werte eingesetzt werden, um einen ohmsch-induktiven Spannungsanteil der Systemantwort zu bestimmen. Ausgehend von dem bestimmten ohmsch-induktiven Spannungsanteil wird der Strangwiderstand bestimmt und bereitgestellt, wobei hierzu insbesondere angenommen wird, dass sich die Induktivitäten der elektrischen Maschine nahezu nicht mit der Temperatur des Stators verändern, sodass der Strangwiderstand aus dem ohmsch-induktiven Spannungsanteil bestimmt werden kann.

Ein Vorteil des Verfahrens und der Vorrichtung ist, dass der Strangwiderstand während eines normalem Betriebs der elektrischen Maschine, das heißt, insbesondere auch bei einer Drehmomentanforderung an die elektrische Maschine, die größer ist als Null, bestimmt werden kann. Insbesondere kann das Verfahren auch ausgeführt werden, während ein drehmomentbildender q-Strom einen von Null verschiedenen Wert hat. Hierdurch ruft das Verfahren keinerlei Nachteile bei der Drehmomentdynamik hervor. Insbesondere wird das Verfahren während einer normalen Steuerung oder Regelung des Drehmoments der elektrischen Maschine ausgeführt.

Die Strangströme werden insbesondere mittels einer hierfür geeigneten Sensorik, insbesondere mittels Stromsensoren an den einzelnen Strängen, erfasst und bereitgestellt. Die hochaufgelöst erfassten Strangströme können insbesondere dazu verwendet werden, zu einer mittensynchronen Abtastung äquivalente Werte der Strangströme zu erzeugen. Durch das hochaufgelöste Erfassen kann insbesondere ein Rauschen verbessert in den äquivalenten Werten herausgefiltert werden, sodass insbesondere ein Signal-zu-Rauschverhältnis verbessert werden kann.

Die Strangspannungen können insbesondere ausgehend von den erfassten Strangströmen und einer Modulationsansteuerung des Pulswechselrichters bestimmt werden. Hierbei ist vorgesehen, dass eine Totzeitkompensation erfolgt, welche weiter unten noch näher beschrieben wird.

Eine Rotorlage eines Rotors ist insbesondere ein Rotorlagewinkel des Rotors. Eine Rotorlage kann beispielsweise mittels einer entsprechenden Sensorik, beispielsweise mittels eines Drehgebers, erfasst und bereitgestellt werden.

Die Steuereinrichtung kann einzeln oder zusammengefasst als eine Kombination von Hardware und Software ausgebildet sein, beispielsweise als Programmcode, der auf einem Mikrocontroller oder Mikroprozessor ausgeführt wird. Es kann jedoch auch vorgesehen sein, dass Teile einzeln oder zusammengefasst als anwendungsspezifische integrierte Schaltung (ASIC) oder feldprogrammierbares Gatterfeld (FPGA) ausgebildet sind.

Es ist hierbei insbesondere vorgesehen, dass die hochfrequent erfassten, insbesondere überabgetasteten, Strangströme und gegebenenfalls auch andere Größen mittels eines feldprogrammierbaren Gatterfeldes (FPGA) ausgewertet werden. Ein feldprogrammierbares Gatterfeld ermöglicht eine hochfrequente Signalerfassung und Signalverarbeitung. Hochfrequent soll hierbei insbesondere bedeuten, dass ein zugehöriger Frequenzbereich oberhalb einer Modulationsfrequenz einer Pulsdauermodulation des Pulswechselrichters liegt. Insbesondere bezeichnet hochfrequent eine um einen Faktor 10, bevorzugt um einen Faktor 100, besonders bevorzugt um einen Faktor 1000 größere Frequenz im Vergleich zu der Modulationsfrequenz. Ist eine Modulationsfrequenz beispielsweise 20 kHz, so ist eine Frequenz der Signalerfassung und Signalverarbeitung des feldprogrammierbaren Gatterfeldes beispielsweise 1 MHz. Durch die parallele Signalverarbeitung eines feldprogrammierbaren Gatterfeldes kann dieses mit Vorteil hochfrequent (insbesondere ~MHz) abgetastete Größen verarbeiten. Durch die hochfrequente Abtastung lassen sich Abtast- bzw. Aliasing-Effekte als Störgrößen im Signal reduzieren. Eventuelle Rauschanteile der Sensorik können im feldprogrammierbaren Gatterfeld digital gefiltert werden, sodass ein sehr großes Signal-zu-Rausch-Verhältnis für die digitale Weiterverarbeitung bereitgestellt werden kann. Im Vergleich dazu ist ein Mikrocontroller (z.B. DSP) deutlich weniger geeignet, um hochfrequente Signale zu verarbeiten, da die erfassten Werte des DSP jeweils vom erfassenden internen Analog-Digital-Wandler (ADC) zum Prozessorkern transportiert und verarbeitet werden müssen, was zu signallaufzeitbedingten und vorverarbeitungsbedingten Verzögerungen beim Auswerten führt. Bei einem feldprogrammierbaren Gatterfeld stehen die erfassten Werte des ADC den Logikeinheiten stattdessen unmittelbar, das heißt in Echtzeit, zur Verfügung. Auch können mit feldprogrammierbaren Gatterfeldern kostengünstige ADCs ohne weitere Maßnahmen ausgewertet werden, welche einen hochfrequenten digitalen Datenstrom (Bitstrom) erzeugen können, z.B. Delta-Sigma Wandler. Das feldprogrammierbare Gatterfeld ist insbesondere Teil eines System-on-Chip (SoC).

Das feldprogrammierbare Gatterfeld kann insbesondere ein zur Laufzeit partiell (d.h. teilweise) umkonfigurierbares feldprogrammierbares Gatterfeld sein. Hierdurch ist das feldprogrammierbare Gatterfeld insbesondere updatefähig. Das Umkonfigurieren erfolgt insbesondere im Wege der partiellen Umkonfiguration, bei der nur ein Teil des Gatterfeldes zur Laufzeit umkonfiguriert bzw. umprogrammiert wird, andere Teile des Gatterfeldes jedoch ihre jeweilige Konfiguration bzw. Programmierung beibehalten. Das Umkonfigurieren wird insbesondere mittels einer Konfigurationssteuerung durchgeführt, welche das Umkonfigurieren durchführt und überwacht. Die Konfigurationssteuerung kann mittels eines DSPs oder der Steuereinrichtung der Vorrichtung bereitgestellt werden. Zum Umkonfigurieren des mindestens einen feldprogrammierbaren Gatterfelds können insbesondere Verfahren zur automatischen Codegenerierung eingesetzt werden, wie beispielsweise der "Xilinx System Generator for DSP", welcher sowohl eine Quellcode-Modellierung als auch eine Funktionsanalyse automatisiert durchführen kann. Der "System Generator for DSP" ermöglicht beispielsweise die Modellierung von FPGA-Funktionen in einer Matlab Simulink-Umgebung, sodass die Eigenschaften gegenüber weiteren Simulink-Funktionsblöcken getestet werden können. Durch die automatische Codegenerierung kann sichergestellt werden, dass sich das feldprogrammierbare Gatterfeld identisch zur Simulink-Modellierung verhält. Eine Konfiguration eines feldprogrammierbaren Gatterfeldes umfasst insbesondere Anweisungen, mit denen das feldprogrammierbare Gatterfeld derart programmiert werden kann, dass mittels des programmierten (bzw. konfigurierten oder umkonfigurierten) Teils des feldprogrammierbaren Gatterfeldes eine bestimmte Funktionalität zur Datenverarbeitung bereitgestellt werden kann. Vorliegend ist eine solche Funktionalität insbesondere das Durchführen von Maßnahmen des in dieser Offenbarung beschriebenen Verfahrens.

Es ist vorgesehen, dass in dem Pulswechselrichter aufgrund von Schaltverzugszeiten auftretende Totzeiteffekte mittels einer Totzeitkompensation kompensiert werden. Dies erfolgt insbesondere mittels der Steuereinrichtung, insbesondere mittels mindestens eines feldprogrammierbaren Gatterfeldes der Steuereinrichtung. Die Totzeitkompensation versucht, einen Totzeiteffekt zu kompensieren. Der Totzeiteffekt tritt auf, weil es aufgrund von Schaltzeiten von Leistungshalbleitern des Pulswechselrichters zu einem Abbildungsfehler zwischen einer geschätzten aktuellen Spannung und einer realen Spannung kommt. Zum Kompensieren des Totzeiteffekts werden Schaltflanken von Leistungshalbleitern angepasst, das heißt hinsichtlich eines Schaltzeitpunkts verschoben. Hierdurch können tatsächlich vorliegende aktuelle Strangspannungen unter Berücksichtigung von den hochfrequent erfassten Strangströmen präzise bestimmt, insbesondere geschätzt werden. Die Totzeitkompensation wird beispielsweise mittels des in B. Weber, T. Brandt and A. Mertens, Compensation of switching dead-time effects in voltage-fed PWM inverters using FPGA-based current oversampling, 2016 IEEE Applied Power Electronics Conference and Exposition (APEC), Long Beach, CA, USA, 2016, S. 3172-3179, doi: 10.1109/APEC.2016.7468318, beschriebenen Verfahrens durchgeführt.

Das Vorgehen zum Bestimmen des Strangwiderstands wird nachfolgend anhand der Stator-Spannungsdifferentialgleichung einer permanentmagneterregten Synchronmaschine erläutert. Bei Asynchronmaschinen ist das Vorgehen grundsätzlich aber analog.

Die permanentmagneterregte Synchronmaschine lässt sich durch nachfolgende Statorspannungs-Differentialgleichungen in statorfesten $\alpha\beta$-Koordinaten modellieren:

$$\begin{pmatrix} u_\alpha \\ u_\beta \end{pmatrix} = R \cdot \begin{pmatrix} i_\alpha \\ i_\beta \end{pmatrix} + \frac{d}{dt}\left(\left(\Sigma L \begin{pmatrix} 1 & 0 \\ 0 & 1 \end{pmatrix} + \Delta L \begin{pmatrix} \cos(2\gamma_{el}) & \sin(2\gamma_{el}) \\ \sin(2\gamma_{el}) & -\cos(2\gamma_{el}) \end{pmatrix}\right) \cdot \begin{pmatrix} i_\alpha \\ i_\beta \end{pmatrix}\right) + \frac{d}{dt}\psi_{PM}\begin{pmatrix} \cos(2\gamma_{el}) \\ \sin(2\gamma_{el}) \end{pmatrix}$$

Hierbei sind:

$$\Sigma L = \frac{L_d + L_q}{2} \text{ und } \Delta L = \frac{L_d - L_q}{2},$$

- $L_d$ die Induktivität der elektrischen Maschine in Bezug auf die d-Achse des Rotors (engl. direct axis),
- $L_q$ die Induktivität der elektrischen Maschine in Bezug auf die q-Achse des Rotors (engl. quadrature axis),
- $R$ der Strangwiderstand der elektrischen Maschine,
- $\psi_{PM}$ die Flussverkettung des Rotors auf Grund der Permanentmagnete,
- $\gamma_{el}$ die elektrische Rotorlage (d.h. der elektrische Rotorlagewinkel),
- $u_\alpha, u_\beta$ die Statorspannungen in statorfesten $\alpha\beta$-Koordinaten und
- $i_\alpha, i_\beta$ die Statorströme in statorfesten $\alpha\beta$-Koordinaten.

Die Strangspannungen und die Strangströme lassen sich in die Statorspannungen und Statorströme in $\alpha\beta$-Koordinaten umrechnen.

Die Induktivitätswerte $L_d$ und $L_q$ sind nahezu nicht temperaturabhängig und können, beispielweise vor Anwendung des Verfahrens, vermessen werden bzw. sind für eine Baureihe eines Maschinentyps der elektrischen Maschine bekannt. Temperaturabhängig sind vor allem der Strangwiderstand R sowie die Flussverkettung $\psi_{PM}$. In der Regel erhöht sich R mit der Temperatur und $\psi_{PM}$ nimmt mit der Temperatur ab.

Durch die Spannungsbildung des Pulswechselrichters wird das hochfrequente Testsignal auf die elektrische Maschine eingeprägt. Dieses hochfrequente Testsignal ist jedoch derart kurz (insbesondere Zeitraum von etwa 1 bis 10 Pulsperioden des Pulswechselrichters) gewählt, dass eine Gegenspannung der elektrischen Maschine als nahezu konstant angenähert werden kann. Der ohmsch-induktive Spannungsanteil reagiert mit einer gleichfrequenten Systemantwort:

$$R \cdot \begin{pmatrix} i_\alpha \\ i_\beta \end{pmatrix} + \frac{d}{dt}\left( \left( \Sigma L \begin{pmatrix} 1 & 0 \\ 0 & 1 \end{pmatrix} + \Delta L \begin{pmatrix} \cos(2\gamma_{el}) & \sin(2\gamma_{el}) \\ \sin(2\gamma_{el}) & -\cos(2\gamma_{el}) \end{pmatrix} \right) \cdot \begin{pmatrix} i_\alpha \\ i_\beta \end{pmatrix} \right)$$

wohingegen ein Spannungsanteil des Rotors demgegenüber eine Gleichgröße ist:

$$\frac{d}{dt}\psi_{PM} \begin{pmatrix} \cos(2\gamma_{el}) \\ \sin(2\gamma_{el}) \end{pmatrix}$$

Dies sei im Folgenden näher erläutert:
Der Spannungsanteil des Rotors ist durch seine Drehzahl vorgegeben, was einer mechanischen Trägheit unterliegt. Dieser Spannungsanteil kann in kurzen Zeiträumen von etwa 1 bis 10 Pulsdauerperioden des Pulswechselrichters demnach als Gleichgröße angesehen werden. Wird nun ein hochfrequentes Trägersignal bzgl. der Strangspannungen der elektrischen Maschine durch die Modulation des Pulswechselrichters eingeprägt, so zeigt der obige ohmsch-induktive Spannungsanteil eine gleichfrequente Spannungsantwort. Mit einem Beobachter, beispielsweise durch Auswerten ganzer Perioden einer Trägerfrequenz des Testsignals, lässt sich somit der ohmsch-induktive Spannungsanteil separieren. Da sich die Induktivitäten der Maschine nahezu nicht mit der Temperatur des Stators verändern, lässt sich der Strangwiderstand R bestimmen. Ein Beobachter ist insbesondere ein regelungstechnischer Beobachter (engl. state observer), der ausgehend von einem Modell der elektrischen Maschine einen Zustand der elektrischen Maschine schätzt. Der geschätzte Zustand der elektrischen Maschine wird mit einem Istzustand der elektrischen Maschine verglichen und bei Abweichungen wird mindestens ein Parameter des Modells so lange angepasst, bis der geschätzte Zustand und der Istzustand wieder übereinstimmen. Der angepasste Parameter ist vorliegend insbesondere der Strangwiderstand R.

Das Verfahren und die Vorrichtung können beispielsweise in einem Kraftfahrzeug eingesetzt werden, insbesondere in einem Elektrofahrzeug oder einem Hybridfahrzeug. Grundsätzlich können das Verfahren und die Vorrichtung aber auch in anderen Gebieten eingesetzt werden, insbesondere auch in anderen Land-, Schienen-, Wasser-, Luft- oder Raumfahrzeugen, wie beispielsweise in Drohnen oder Lufttaxis.

In einer Ausführungsform ist vorgesehen, dass ein im zeitlichen Verlauf gemittelter Strangwiderstand bestimmt und bereitgestellt wird. Hierdurch können kurzzeitige Schwankungen des Strangwiderstands im Ergebnis weggemittelt werden.

In einer Ausführungsform ist vorgesehen, dass ausgehend von dem bestimmten Strangwiderstand eine Statortemperatur eines Stators der elektrischen Maschine geschätzt wird und/oder dass ausgehend von dem gemittelten Strangwiderstand eine gemittelte Statortemperatur eines Stators der elektrischen Maschine geschätzt wird. Hierdurch kann ein Schätzwert für die Statortemperatur bereitgestellt werden, die eine wichtige Größe beim Beurteilen eines Zustands der elektrischen Maschine und beim Bestimmen von maximalen Wertebereichen von Betriebsparametern, insbesondere einer Dauermaximalleistung und einer dynamischen Überlastfähigkeit, der elektrischen Maschine ist. Insbesondere kann eine Kennlinie zum Schätzen der Statortemperatur aus dem bestimmten Strangwiderstand und/oder dem gemittelten Strangwiderstand verwendet werden. Die Kennlinie kann beispielsweise anhand von empirischen Messungen auf einem Prüfstand, bei denen sowohl ein Strangwiderstand als auch eine Statortemperatur gemessen wird, erzeugt werden. Alternativ oder zusätzlich kann die Kennlinie auch durch Verwendung von Simulationen erzeugt worden sein. Die Kennlinie ist dann beispielsweise in einem Speicher der Steuereinrichtung hinterlegt.

Die Kennlinie kann beispielsweise als Nachschlagetabelle vorgehalten werden, aus der Werte abgerufen werden und bei Bedarf interpoliert werden. Alternativ können auch Funktionen an empirische Messwerte angepasst werden.

In einer Ausführungsform ist vorgesehen, dass ausgehend von dem bestimmten Strangwiderstand und/oder dem gemittelten Strangwiderstand und/oder der geschätzten Statortemperatur und/oder der gemittelten Statortemperatur eine Steuerung oder Regelung der elektrischen Maschine angepasst wird. Hierdurch kann eine Steuerung und/oder Regelung direkt auf Grundlage eines aktuellen und/oder gemittelten Wertes für den Strangwiderstand und/oder die Statortemperatur angepasst werden, sodass die elektrische Maschine stets auf Grundlage von aktuellen Parameterwerten gesteuert und/oder geregelt wird.

In einer weiterbildenden Ausführungsform ist vorgesehen, dass zum Anpassen in der Steuerung oder in der Regelung eine Maximaldauerleistung und/oder eine dynamische Überlastfähigkeit der elektrischen Maschine verändert werden. Insbesondere werden zugehörige Betriebsparameter verändert. Hierdurch kann die elektrische Maschine in Abhängigkeit eines aktuellen Wertes oder aktuellen Mittelwertes stets mit einer maximal möglichen bzw. maximal erreichbaren Maximaldauerleistung und/oder maximal möglichen dynamischen Überlastfähigkeit betrieben werden. Insbesondere können hierdurch zu jedem Zeitpunkt sowohl eine Leistungsfähigkeit als auch eine Lebensdauer verbessert werden. Anders ausgedrückt kann hierdurch eine schädliche Überlastung zu jedem Zeitpunkt vermieden werden, was zu einer Erhöhung der Lebensdauer führt.

In einer Ausführungsform ist vorgesehen, dass die Strangströme und zeitliche Strangstromverläufe während einer Dauer von aktiven Spannungszuständen hochfrequent erfasst werden. Das hochfrequente Testsignal wird dann während der aktiven Spannungszustände eingeprägt. Die Auswertung der Strangströme während der aktiven Spannungszustände bietet sich insbesondere bei Arbeitspunkten mit hohen Modulationsgraden des Pulswechselrichters an, bspw. bei hohen Drehzahlen.

In einer Ausführungsform ist vorgesehen, dass die Strangströme während Nullspannungszuständen (in denen die elektrische Maschine insbesondere kurzgeschlossen ist) erfasst werden und ein Verlauf der Strangströme während der aktiven Spannungszustände aus den während der Nullspannungszuständen erfassten Strangströmen rekonstruiert wird. Sind die aktiven Spannungszustände zeitlich sehr kurz, so können die Stromverläufe bezüglich dieser Zeiträume vorteilhaft aus den erfassten Stromverläufen während der Nullspannungszustände rekonstruiert werden.

In einer Ausführungsform ist vorgesehen, dass die Rotorlage im Rahmen einer geberlosen Regelung der elektrischen Maschine geschätzt wird. Ein Verfahren zum Schätzen einer Rotorlage und/oder einer Rotordrehzahl ist beispielsweise aus Bastian Weber, Positionsgeberlose Regelung von permanentmagneterregten Synchronmaschinen bei kleinen Drehzahlen mit überabtastender Stromerfassung, Hannover, Gottfried Wilhelm Leibniz Universität Hannover, Dissertation, 2018, 163 S., https://doi.org/10.15488/9140, bekannt.

In einer weiterbildenden Ausführungsform ist vorgesehen, dass eine Rotorlageschätzung der geberlosen Regelung deaktiviert wird, wenn eine Drehmomentanforderung an die elektrische Maschine einen Schwellenwert unterschreitet und/oder Null ist, wobei eine Rotorlage nach dem Deaktivieren aus bisher geschätzten Rotorlagen extrapoliert wird, wobei der Strangwiderstand bestimmt wird, während die Rotorlageschätzung deaktiviert ist, und wobei die Rotorlageschätzung nach dem Bestimmen des Strangwiderstands wieder aktiviert wird. Hierdurch kann ein eventuell auftretender störender Einfluss der Rotorlageschätzung der geberlosen Regelung, weil beispielsweise nicht alle notwendigen Größen gleichzeitig bestimmt werden können, vermieden werden. Anders ausgedrückt wird bei sehr geringen oder verschwindenden Drehmomentanforderungen ein Aussetzbetrieb durchgeführt, während dessen die Maßnahmen zum Bestimmen des Strangwiderstands durchgeführt werden. Ist die Drehmomentanforderung an die elektrische Maschine in einem kurzen Zeitraum von etwa 4 PWM-Perioden sehr gering oder Null, so wird die Rotorlageschätzung der geberlosen Regelung kurzzeitig deaktiviert. Auf Grund der mechanischen Trägheit des Rotors der elektrischen Maschine wird angenommen, dass sich die Drehzahl im Zeitraum von etwa 4 PWM-Perioden nicht verändert, sodass die aktuelle Rotorlage aus den bekannten Werten davor extrapoliert werden kann. Mit deaktivierter geberlosen Regelung wird der Strangwiderstand bestimmt und/oder die Statortemperatur geschätzt. Anschließend wird die geberlose Regelung wieder aktiviert und diese synchronisiert sich wieder auf die elektrische Maschine auf.

Weitere Merkmale zur Ausgestaltung der Vorrichtung ergeben sich aus der Beschreibung von Ausgestaltungen des Verfahrens. Die Vorteile der Vorrichtung sind hierbei jeweils die gleichen wie bei den Ausgestaltungen des Verfahrens.

Nachfolgend wird die Erfindung anhand bevorzugter Ausführungsbeispiele unter Bezugnahme auf die Figuren näher erläutert. Hierbei zeigen:

Fig. 1     eine schematische Darstellung einer Ausführungsform der Vorrichtung zum Bestimmen eines Strangwiderstandes einer elektrischen Maschine;

Fig. 2     eine schematische Darstellung zur Verdeutlichung einer hochfrequenten Erfassung von Strangströmen;

Fig. 3     ein schematisches Ablaufdiagramm einer Ausführungsform des Verfahrens zum Bestimmen eines Strangwiderstandes einer elektrischen Maschine.

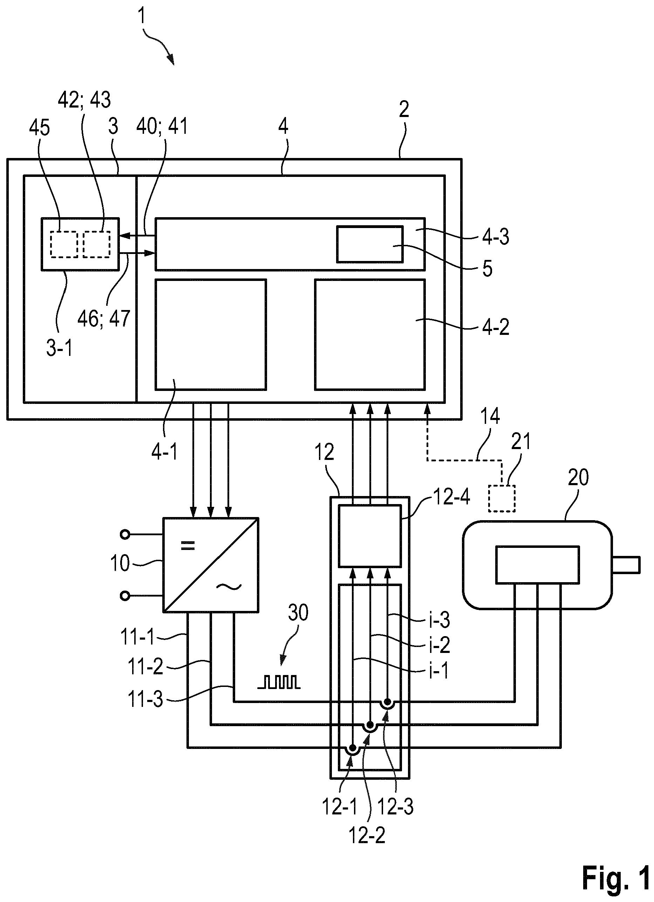

In Fig. 1 ist eine schematische Darstellung einer Ausführungsform der Vorrichtung 1 zum Bestimmen eines Strangwiderstandes 40 einer elektrischen Maschine 20 gezeigt. Die Vorrichtung 1 umfasst eine Steuereinrichtung 2. Die Steuereinrichtung 2 umfasst in der gezeigten Ausführungsform einen Digitalen Signalprozessor 3 und ein feldprogrammierbares Gatterfeld 4. Das feldprogrammierbare Gatterfeld 4 erlaubt eine hochfrequente Signalverarbeitung und Signalauswertung. Der Digitale Signalprozessor 3 und das feldprogrammierbare Gatterfeld 4 sind insbesondere als System-on-Chip-(SoC) ausgebildet. Die Vorrichtung 1 führt das in dieser Offenbarung beschriebene Verfahren aus, welches nachfolgend anhand der Vorrichtung 1 erläutert wird.

Das feldprogrammierbare Gatterfeld 4 umfasst mehrere Module 4-x, die unterschiedliche Funktionen ausführen, wie nachfolgend erläutert wird.

Gezeigt ist ferner ein Pulswechselrichter 10, der im Beispiel als Zweipunktwechselrichter ausgebildet ist, sowie eine Sensorik 12 zum Erfassen von Strangströmen i-x, umfassend Stromsensoren 12-1, 12-2, 12-3 und einen Analog-Digital-Wandler 12-4. Die Sensorik 12 kann auch Teil der Vorrichtung 1 sein. Weiter ist eine elektrische Maschine 20 gezeigt, die von dem Pulswechselrichter 10 über drei Stränge 11-1, 11-2, 11-3 gespeist wird. Zum Speisen erzeugt der Pulswechselrichter 10 in an sich bekannter Weise ein Drehfeld und wird hierzu von einem Modul 4-1 angesteuert. Insbesondere stellt das Modul 4-1 eine Modulationssteuerung bereit.

Mittels der Sensorik 12 werden die Strangströme i-x der elektrischen Maschine 20 hochfrequent erfasst, von der Steuereinrichtung 2 empfangen und von dem Modul 4-2 verarbeitet.

Insbesondere werden die Strangströme i-x überabgetastet mit einer Abtastfrequenz erfasst, die um einen Faktor 10, 100 oder sogar 1000 über einer Modulationsfrequenz des Pulswechselrichters 10 liegt. Unter Berücksichtigung einer Totzeitkompensation werden, ebenfalls mittels des Moduls 4-2, zugehörige Strangspannungen bestimmt.

Eine Rotorlage 14, d.h. ein elektrischer Rotorlagewinkel, der elektrischen Maschine 20 wird mittels eines Drehgebers 21 erfasst, von der Steuereinrichtung 2 empfangen und dem Modul 4-2 zugeführt, oder im Rahmen einer drehgeberlosen Regelung ausgehend von den erfassten Strangströmen i-x geschätzt. Das Schätzen erfolgt beispielsweise mittels des Moduls 4-2.

Mittels des Moduls 4-1 wird der Pulswechselrichter 10 derart angesteuert, dass dieser ein hochfrequentes Testsignal 30 bezüglich der Strangspannungen durch Modulation erzeugt und aufgeprägt. Hierzu wird der Pulswechselrichter 10 mittels des Moduls 4-1 derart angesteuert, dass eine hochfrequente Schwingung, insbesondere im Bereich von 3 bis 5 kHz oder darüber, beispielsweise mit einer Amplitude von 10 V in die d-Achse eingeprägt wird. Hierdurch werden alle drei Stränge 11-x angeregt.

Mittels eines Beobachters 5, der mittels des Moduls 4-3 bereitgestellt wird, wird ein ohmsch-induktiver Spannungsanteil einer Systemantwort der elektrischen Maschine 20 auf das aufgeprägte hochfrequente Testsignal 30 bestimmt.

Ausgehend von dem bestimmten ohmsch-induktiven Spannungsanteil wird der Strangwiderstand 40 bestimmt und bereitgestellt. Zum Bereitstellen wird der bestimmte Strangwiderstand 40 beispielsweise als analoges oder digitales Signal ausgegeben.

Neben dem Bereitstellen des Beobachters 5 stellt das Modul 4-3 insbesondere auch eine Regelung der elektrischen Maschine 20 bereit, wobei mit den Modulen 4-1 und 4-2 zusammen die Regelschleife realisiert wird.

Es kann vorgesehen sein, dass ein im zeitlichen Verlauf gemittelter Strangwiderstand 41 bestimmt und bereitgestellt wird. Dies erfolgt durch zeitliches Mitteln über mehrere bestimmte Strangwiderstände 40. Dies erfolgt ebenfalls mittels des Moduls 4-3.

Es kann vorgesehen sein, dass ausgehend von dem bestimmten Strangwiderstand 40 eine Statortemperatur 42 eines Stators der elektrischen Maschine 20 geschätzt wird und/oder dass ausgehend von dem gemittelten Strangwiderstand 41 eine gemittelte Statortemperatur 43 eines Stators der elektrischen Maschine 20 geschätzt wird. Dies wird beispielsweise mittels eines Moduls 3-1 des Digitalen Signalprozessors 3 durchgeführt. Hierzu wird beispielsweise eine empirisch bestimmte Kennlinie 45 oder eine Nachschlagetabelle verwendet, in der Werte von Strangwiderständen 40 mit Werten von Statortemperaturen 42 verknüpft hinterlegt sind.

Es kann vorgesehen sein, dass ausgehend von dem bestimmten Strangwiderstand 40 und/oder dem gemittelten Strangwiderstand 41 und/oder der geschätzten Statortemperatur 42 und/oder der gemittelten Statortemperatur 43 eine Steuerung oder Regelung der elektrischen Maschine 20 angepasst wird. Hierzu werden zugehörige Parameter der Steuerung oder Regelung verändert. Die Parameter können hierbei beispielsweise ausgehend von einer in der Steuereinrichtung 2 hinterlegten Kennlinie angepasst werden, in der Werte für den (gemittelten) Strangwiderstand 40 (41) und/oder die geschätzte (gemittelte) Statortemperatur 42 (43) mit den jeweiligen Werten für die Parameter der Steuerung oder Regelung verknüpft sind.

Es kann insbesondere vorgesehen sein, dass zum Anpassen in der Steuerung oder in der Regelung eine Maximaldauerleistung 46 und/oder eine dynamische Überlastfähigkeit 47 der elektrischen Maschine 20 verändert werden. Dies erfolgt beispielsweise ebenfalls ausgehend von Motorkennlinien (nicht gezeigt) der elektrischen Maschine 20, die Werte des Strangwiderstandes 40 mit Werten für die Maximaldauerleistung 46 und/oder die dynamische Überlastfähigkeit 47 verknüpfen. Das Verändern wird beispielsweise im Modul 3-1 des Digitalen Signalprozessors 3 durchgeführt. Die veränderten Werte für die Maximaldauerleistung 46 und/oder die dynamische Überlastfähigkeit 47 werden dem Modul 4-3 zugeführt, welches die elektrische Maschine 20 steuert oder regelt. Das Modul 4-3 passt die Steuerung oder Regelung entsprechend an. Insbesondere wird ein Betriebsparameterbereich der elektrischen Maschine 20 gemäß den geänderten Begrenzungen angepasst.

Es kann vorgesehen sein, dass die Strangströme i-x und zeitliche Strangstromverläufe während einer Dauer von aktiven Spannungszuständen hochfrequent erfasst werden.

Alternativ kann vorgesehen sein, dass die Strangströme i-x während Nullspannungszuständen erfasst werden und ein Verlauf der Strangströme während der aktiven Spannungszustände aus den während der Nullspannungszuständen erfassten Strangströmen rekonstruiert wird. Das Rekonstruieren erfolgt beispielsweise in dem Modul 4-2.

Es kann beim Schätzen der Rotorlage 14 im Rahmen der geberlosen Regelung vorgesehen sein, dass eine Rotorlageschätzung der geberlosen Regelung deaktiviert wird, wenn eine Drehmomentanforderung an die elektrische Maschine 20 einen Schwellenwert unterschreitet und/oder Null ist, wobei eine Rotorlage 14 nach dem Deaktivieren aus bisher geschätzten Rotorlagen 14 extrapoliert wird, wobei der Strangwiderstand 40 bestimmt wird, während die Rotorlageschätzung deaktiviert ist, und wobei die Rotorlageschätzung nach dem Bestimmen des Strangwiderstands 40 wieder aktiviert wird.

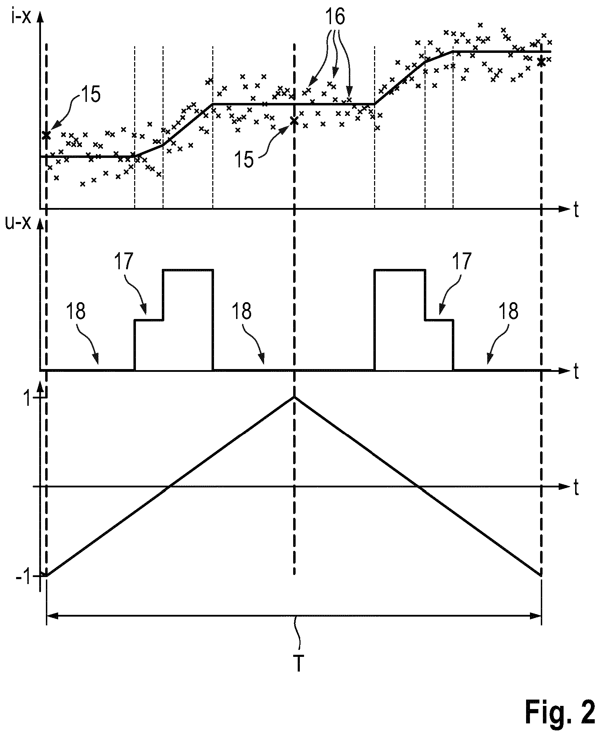

In Fig. 2 ist eine schematische Darstellung zur Verdeutlichung einer hochfrequenten Erfassung von Strangströmen i-x gezeigt. Hierbei sind untereinander beispielhafte zeitliche Verläufe eines Strangstroms i-x, einer Strangspannung u-x und eines Trägersignals einer Pulsweitenmodulation eines Pulswechselrichters über die Zeit t gezeigt, jeweils über eine vollständige Modulationsperiode T des Pulswechselrichters. Hierbei sind sowohl aktive Spannungszustände 17 als auch Nullspannungszustände 18 gezeigt.

Bei der üblicherweise verwendeten mittensynchronen Abtastung werden pro Periode zwei Messwerte 15 des Strangstromes i-x erfasst, nämlich am Angang und in der Mitte der Modulationsperiode T. Beim hochfrequenten Erfassen des Strangstromes i-x werden hingegen pro Modulationsperiode T deutlich mehr Messwerte 16 erfasst (der Übersichtlichkeit halber sind nur ein paar mit einem eigenen Bezugszeichen versehen), insbesondere erfolgt eine Überabtastung, das heißt, eine Abtastfrequenz ist insbesondere um einen Faktor 10, 100 oder sogar 1000 größer als die Modulationsfrequenz des Pulswechselrichters. Daher steht pro Modulationsperiode T ein Vielfaches an Messwerten 16 für den Strangstrom i-x zur Verfügung, was sich positiv auf ein Signal-zu-Rauschverhältnis auswirkt und darüber hinaus eine Mittelwertbildung und/oder Filterung ermöglicht. Ferner stehen über die gesamte Modulationsperiode T stets zeitaktuelle Messwerte 16 zur Verfügung. Insbesondere können auch Stromsteigungen verbessert bestimmt werden.

Durch das hochfrequente Erfassen der Strangströme i-x ist es insbesondere möglich, eine Totzeitkompensation durchzuführen, sodass die realen aktuellen Strangspannungen u-x bestimmt werden können.

Ferner ermöglicht das hochfrequente Erfassen insbesondere, dass ein Strangstrom i-x und ein zeitlicher Strangstromverlauf gezielt während einer Dauer von aktiven Spannungszuständen 17 hochfrequent erfasst werden können.

Weiter ermöglicht das hochfrequente Erfassen insbesondere, dass alternativ ein Strangstrom i-x während der Nullspannungszustände 18 erfasst werden kann und ein Verlauf des Strangstromes i-x während der aktiven Spannungszustände 17 aus dem während der Nullspannungszustände 18 erfassten Strangstrom i-x durch Schätzen rekonstruiert werden kann. Im einfachsten Fall werden die Werte während der aktiven Spannungszustände 17 ausgehend von den Werten vor und nach den aktiven Spannungszuständen 17 interpoliert.

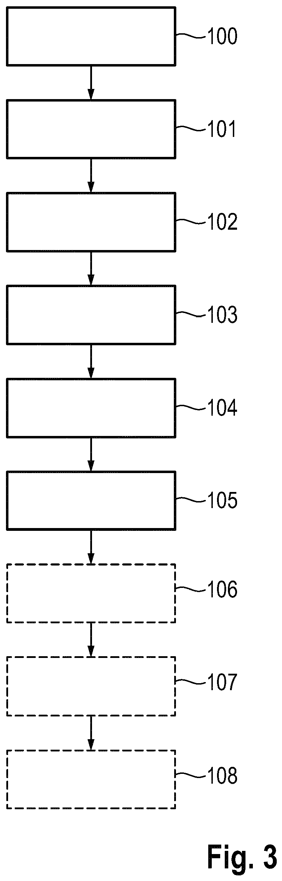

In Fig. 3 ist ein schematisches Ablaufdiagramm einer Ausführungsform des Verfahrens zum Bestimmen eines Strangwiderstandes einer elektrischen Maschine gezeigt.

In einer Maßnahme 100 werden Strangströme der elektrischen Maschine hochfrequent erfasst. Dies erfolgt insbesondere überabgetastet mit einer Abtastfrequenz, die um einen Faktor 10, 100 oder 1000 größer ist als eine Modulationsfrequenz eines Pulswechselrichters, der die elektrische Maschine speist.

In einer Maßnahme 101 werden unter Berücksichtigung einer Totzeitkompensation zugehörige Strangspannungen bestimmt. Insbesondere wird zu jedem Zeitpunkt, zu dem ein Wert für einen Strangstrom erfasst wird, eine zugehörige Strangspannung bestimmt. Dies erfolgt insbesondere ausgehend von den erfassten Strangströmen und einer Modulation des Pulswechselrichters.

In Maßnahme 102 wird eine Rotorlage der elektrischen Maschine erfasst oder geschätzt. Dies kann mittels einer hierfür eingerichteten Sensorik, beispielsweise mittels eines Drehgebers, erfolgen oder im Rahmen einer drehgeberlosen Regelung, bei der die Rotorlage geschätzt wird.

Die Maßnahmen 100 bis 102 werden insbesondere fortlaufend wiederholt und insbesondere zeitgleich ausgeführt, sodass stets aktuelle Werte für die Strangströme, die Strangspannungen und die Rotorlage zur Verfügung stehen.

In Maßnahme 103 wird ein hochfrequentes Testsignal bezüglich der Strangspannungen mittels eines die elektrische Maschine speisenden Pulswechselrichters durch Modulation erzeugt und aufgeprägt. Insbesondere wird das hochfrequente Testsignal hierbei in eine d-Achse aufgeprägt. Eine Frequenz des hochfrequenten Testsignals liegt hierbei beispielsweise bei 3 bis 5 kHz oder darüber und eine Amplitude beispielsweise im Bereich von 10 V.

In einer Maßnahme 104 wird mittels eines Beobachters ein ohmsch-induktiver Spannungsanteil einer Systemantwort der elektrischen Maschine auf das aufgeprägte hochfrequente Testsignal bestimmt.

In einer Maßnahme 105 wird ausgehend von dem bestimmten ohmsch-induktiven Spannungsanteil der Strangwiderstand bestimmt und bereitgestellt wird. Zum Bereitstellen wird der bestimmte Strangwiderstand beispielsweise als analoges oder digitales Signal ausgegeben.

In einer Maßnahme 106 kann vorgesehen sein, dass ein im zeitlichen Verlauf gemittelter Strangwiderstand bestimmt und bereitgestellt wird.

In einer Maßnahme 107 kann vorgesehen sein, dass ausgehend von dem bestimmten Strangwiderstand eine Statortemperatur eines Stators der elektrischen Maschine geschätzt wird und/oder dass ausgehend von dem gemittelten Strangwiderstand eine gemittelte Statortemperatur eines Stators der elektrischen Maschine geschätzt wird.

In einer Maßnahme 108 kann vorgesehen sein, dass ausgehend von dem bestimmten Strangwiderstand und/oder dem gemittelten Strangwiderstand und/oder der geschätzten Statortemperatur und/oder der gemittelten Statortemperatur eine Steuerung oder Regelung der elektrischen Maschine angepasst wird.

Es kann in Maßnahme 108 vorgesehen sein, dass zum Anpassen in der Steuerung oder in der Regelung eine Maximaldauerleistung und/oder eine dynamische Überlastfähigkeit der elektrischen Maschine verändert werden.

Es kann in Maßnahme 101 vorgesehen sein, dass die Strangströme und zeitliche Strangstromverläufe während einer Dauer von aktiven Spannungszuständen hochfrequent erfasst werden.

Alternativ kann in Maßnahme 101 vorgesehen sein, dass die Strangströme während Nullspannungszuständen erfasst werden und ein Verlauf der Strangströme während der aktiven Spannungszustände aus den während der Nullspannungszuständen erfassten Strangströmen rekonstruiert wird.

Es kann in Maßnahme 102 im Falle, dass die Rotorlage geschätzt wird, vorgesehen sein, dass eine Rotorlageschätzung der geberlosen Regelung deaktiviert wird, wenn eine Drehmomentanforderung an die elektrische Maschine einen Schwellenwert unterschreitet und/oder Null ist, wobei eine Rotorlage nach dem Deaktivieren aus bisher geschätzten Rotorlagen extrapoliert wird, wobei der Strangwiderstand bestimmt wird, während die Rotorlageschätzung deaktiviert ist, und wobei die Rotorlageschätzung nach dem Bestimmen des Strangwiderstands wieder aktiviert wird.

Anschließend ist insbesondere vorgesehen, dass die Maßnahmen wiederholt werden, sodass fortlaufend ein aktueller Strangwiderstand bzw. eine aktuelle Statortemperatur bereitgestellt werden können und die Steuerung oder Regelung der elektrischen Maschine fortlaufend an diese angepasst werden kann.

**Bezugszeichenliste**

| | |
|---|---|
| 1 | Vorrichtung |
| 2 | Steuereinrichtung |
| 3 | Digitaler Signalprozessor |
| 4 | feldprogrammierbares Gatterfeld |
| 4-x | Modul |
| 5 | Beobachter |
| 10 | Pulswechselrichter |
| 11-x | Strang |
| 12 | Sensorik |
| 12-1 | Stromsensor |
| 12-1 | Stromsensor |
| 12-1 | Stromsensor |
| 12-4 | Digital-Analog-Wandler |
| 14 | Rotorlage |
| 15 | Messwert |
| 16 | Messwert |
| 17 | aktiver Spannungszustand |
| 18 | Nullspannungszustand |
| 20 | elektrische Maschine |
| 21 | Drehgeber |
| 30 | hochfrequentes Testsignal |
| 40 | Strangwiderstand |
| 41 | gemittelter Strangwiderstand |
| 42 | Statortemperatur |
| 43 | gemittelte Statortemperatur |
| 45 | Kennlinie |
| 46 | Maximaldauerleistung |
| 47 | dynamische Überlastfähigkeit |
| 100-108 | Maßnahme |
| i-x | Strangstrom |
| u-x | Strangspannung |
| t | Zeit |
| T | Modulationsperiode |

**Patentansprüche**

1. Verfahren zum Bestimmen eines Strangwiderstandes (40) einer elektrischen Maschine (20), wobei Strangströme (i-x) der elektrischen Maschine (20) hochfrequent erfasst werden, wobei unter Berücksichtigung einer Totzeitkompensation zugehörige Strangspannungen (u') bestimmt werden, wobei eine Rotorlage (14) der elektrischen Maschine (20) erfasst oder geschätzt wird, wobei ein hochfrequentes Testsignal (30) bezüglich der Strangspannungen (u-x) mittels eines die elektrische Maschine (20) speisenden Pulswechselrichters (10) durch Modulation erzeugt und aufgeprägt wird, wobei mittels eines Beobachters (5) ein ohmsch-induktiver Spannungsanteil einer Systemantwort der elektrischen Maschine (20) auf das aufgeprägte hochfrequente Testsignal (30) bestimmt wird, und wobei ausgehend von dem bestimmten ohmsch-induktiven Spannungsanteil der Strangwiderstand (40) bestimmt und bereitgestellt wird.

2. Verfahren nach Anspruch 1, **dadurch gekennzeichnet, dass** ein im zeitlichen Verlauf gemittelter Strangwiderstand (41) bestimmt und bereitgestellt wird.

3. Verfahren nach Anspruch 1, **dadurch gekennzeichnet, dass** ausgehend von dem bestimmten Strangwiderstand (40) eine Statortemperatur (42) eines Stators der elektrischen Maschine (20) geschätzt wird.

4. Verfahren nach Anspruch 2, **dadurch gekennzeichnet, dass** ausgehend von dem gemittelten Strangwiderstand (41) eine gemittelte Statortemperatur (43) eines Stators der elektrischen Maschine (20) geschätzt wird.

5. Verfahren nach Anspruch 2, **dadurch gekennzeichnet, dass** ausgehend von dem bestimmten Strangwiderstand (40) eine Statortemperatur (42) eines Stators der elektrischen Maschine (20) geschätzt wird und von dem gemittelten Strangwiderstand (41) eine gemittelte Statortemperatur (43) des Stators der elektrischen Maschine (20) geschätzt wird.

6. Verfahren nach einem der Ansprüche 1 bis 5, **dadurch gekennzeichnet**, dass ausgehend von dem bestimmten Strangwiderstand (40) und/oder dem gemittelten Strangwiderstand (41) und/oder der geschätzten Statortemperatur (42) und/oder der gemittelten Statortemperatur (43) eine Steuerung oder Regelung der elektrischen Maschine (20) angepasst wird.

7. Verfahren nach Anspruch 6, **dadurch gekennzeichnet, dass** zum Anpassen in der Steuerung oder in der Regelung eine Maximaldauerleistung (46) und/oder eine dynamische Überlastfähigkeit (47) der elektrischen Maschine (20) verändert werden.

8. Verfahren nach einem der vorangegangenen Ansprüche, **dadurch gekennzeichnet, dass** die Strangströme (i-x) und zeitliche Strangstromverläufe während einer Dauer von aktiven Spannungszuständen (17) hochfrequent erfasst werden.

9. Verfahren nach einem der Ansprüche 1 bis 7, **dadurch gekennzeichnet, dass** die Strangströme (i-x) während Nullspannungszuständen (18) erfasst werden und ein Verlauf der Strangströme (i-x) während der aktiven Spannungszustände (17) aus den während der Nullspannungszustände (18) erfassten Strangströmen (i-x) rekonstruiert wird.

10. Verfahren nach einem der vorangegangenen Ansprüche, **dadurch gekennzeichnet, dass** die Rotorlage (14) im Rahmen einer geberlosen Regelung der elektrischen Maschine (20) geschätzt wird.

11. Verfahren nach Anspruch 10, **dadurch gekennzeichnet, dass** eine Rotorlageschätzung der geberlosen Regelung deaktiviert wird, wenn eine Drehmomentanforderung an die elektrische Maschine (20) einen Schwellenwert unterschreitet und/oder Null ist, wobei eine Rotorlage (14) nach dem Deaktivieren aus bisher geschätzten Rotorlagen (14) extrapoliert wird, wobei der Strangwiderstand (40) bestimmt wird, während die Rotorlageschätzung deaktiviert ist, und wobei die Rotorlageschätzung nach dem Bestimmen des Strangwiderstands (40) wieder aktiviert wird.

12. Vorrichtung (1) zum Bestimmen eines Strangwiderstandes (40) einer elektrischen Maschine (20), umfassend eine Steuereinrichtung (2), wobei die Steuereinrichtung (2) dazu eingerichtet ist, hochfrequent erfasste Strangströme (i-x) zu empfangen, unter Berücksichtigung einer Totzeitkompensation zugehörige Strangspannungen (u-x) zu bestimmen, eine erfasste oder geschätzte Rotorlage (14) der elektrischen Maschine (20) zu empfangen, einen die elektrische Maschine (20) speisenden Pulswechselrichter (10) derart anzusteuern, dass dieser durch Modulation ein hochfrequentes Testsignal (30) bezüglich der Strangspannungen (u-x) erzeugt und aufprägt, mittels eines Beobachters (5) einen ohmsch-induktiven Spannungsanteil einer Systemantwort der elektrischen Maschine (20) auf das aufgeprägte hochfrequente Testsignal (30) zu bestimmen, und ausgehend von dem bestimmten ohmsch-induktiven Spannungsanteil den Strangwiderstand (40) zu bestimmen und bereitzustellen.

## EP 4 341 703 B1

**Claims**

1. Method for determining a phase resistance (40) of an electric machine (20), wherein phase currents (i-x) of the electric machine (20) are detected at high frequency, wherein associated phase voltages (u') are determined taking into account a dead-time compensation, wherein a rotor position (14) of the electric machine (20) is detected or estimated, wherein a high-frequency test signal (30) with respect to the phase voltages (u-x) is generated and impressed by modulation by means of a pulse inverter (10) that supplies the electric machine (20), wherein an ohmic-inductive voltage portion of a system response of the electric machine (20) to the impressed high-frequency test signal (30) is determined by means of an observer (5), and wherein, on the basis of the determined ohmic-inductive voltage portion, the phase resistance (40) is determined and provided.

2. Method according to claim 1, **characterized in that** a phase resistance (41) averaged over time is determined and provided.

3. Method according to claim 1, **characterized in that** a stator temperature (42) of a stator of the electric machine (20) is estimated on the basis of the determined phase resistance (40).

4. Method according to claim 2, **characterized in that** an averaged stator temperature (43) of a stator of the electric machine (20) is estimated on the basis of the averaged phase resistance (41).

5. Method according to claim 2, **characterized in that** a stator temperature (42) of a stator of the electric machine (20) is estimated on the basis of the determined phase resistance (40), and an averaged stator temperature (43) of the stator of the electric machine (20) is estimated on the basis of the averaged phase resistance (41).

6. Method according to any of claims 1 to 5, **characterized in that** open-loop or closed-loop control of the electric machine (20) is adapted on the basis of the determined phase resistance (40) and/or the averaged phase resistance (41) and/or the estimated stator temperature (42) and/or the averaged stator temperature (43).

7. Method according to claim 6, **characterized in that** a maximum continuous power (46) and/or a dynamic overload capacity (47) of the electric machine (20) are changed for adaptation in the open-loop or closed-loop control.

8. Method according to any of the preceding claims, **characterized in that** the phase currents (i-x) and temporal phase current profiles are detected at high frequency during a duration of active voltage conditions (17).

9. Method according to any of claims 1 to 7, **characterized in that** the phase currents (i-x) are detected during zero voltage conditions (18), and a profile of the phase current (i-x) during the active voltage conditions (17) is reconstructed from the phase currents (i-x) detected during the zero voltage conditions (18).

10. Method according to any of the preceding claims, **characterized in that** the rotor position (14) is estimated within the context of a sensorless closed-loop control of the electric machine (20).

11. Method according to claim 10, **characterized in that** a rotor position estimation of the sensorless closed-loop control is deactivated when a torque request to the electric machine (20) does not meet a threshold value and/or is zero, a rotor position (14) being extrapolated from previously estimated rotor positions (14) after deactivation, the phase resistance (40) being determined while the rotor position estimation is deactivated, and the rotor position estimation being reactivated after the phase resistance (40) has been determined.

12. Apparatus (1) for determining a phase resistance (40) of an electric machine (20), comprising a control device (2), wherein the control device (2) is configured to receive phase currents (i-x) detected at a high frequency, to determine associated phase voltages (u-x) taking into account dead-time compensation, to receive a detected or estimated rotor position (14) of the electric machine (20), to control a pulse inverter (10) that supplies the electric machine (20) in such a way that it generates and impresses a high-frequency test signal (30), with respect to the phase voltages (u-x), by modulation, to determine, by means of an observer (5), an ohmic-inductive voltage portion of a system response of the electric machine (20) to the impressed high-frequency test signal (30), and to determine and provide the phase resistance (40) on the basis of the determined ohmic-inductive voltage portion.

**Revendications**

1. Procédé de détermination d'une résistance de phase (40) d'une machine électrique (20), dans lequel des courants de phase (i-x) de la machine électrique (20) sont détectés à haute fréquence, dans lequel des tensions de phase associées (u') sont déterminées en tenant compte d'une compensation de temps mort, dans lequel une position de rotor (14) de la machine électrique (20) est détectée ou estimée, dans lequel un signal de test à haute fréquence (30) concernant les tensions de phase (u-x) est généré et appliqué par modulation par le biais d'un onduleur à impulsions (10) alimentant la machine électrique (20), dans lequel une composante de tension ohmique-inductive d'une réponse système de la machine électrique (20) au signal de test à haute fréquence (30) appliqué est déterminée par le biais d'un observateur (5), et dans lequel la résistance de phase (40) est déterminée et mise à disposition à partir de la composante de tension ohmique-inductive déterminée.

2. Procédé selon la revendication 1, **caractérisé en ce qu'**une résistance de phase (41) moyennée dans l'évolution temporelle est déterminée et mise à disposition.

3. Procédé selon la revendication 1, **caractérisé en ce qu'**une température de stator (42) d'un stator de la machine électrique (20) est estimée à partir de la résistance de phase (40) déterminée.

4. Procédé selon la revendication 2, **caractérisé en ce qu'**une température de stator moyenne (43) d'un stator de la machine électrique (20) est estimée à partir de la résistance de phase moyenne (41).

5. Procédé selon la revendication 2, **caractérisé en ce que,** à partir de la résistance de phase (40) déterminée, une température de stator (42) d'un stator de la machine électrique (20) est estimée et, à partir de la résistance de phase moyenne (41), une température de stator moyenne (43) du stator de la machine électrique (20) est estimée.

6. Procédé selon l'une des revendications 1 à 5, **caractérisé en ce que,** à partir de la résistance de phase (40) déterminée et/ou de la résistance de phase moyenne (41) et/ou de la température de stator (42) estimée et/ou de la température de stator moyenne (43), une commande ou une régulation de la machine électrique (20) est adaptée.

7. Procédé selon la revendication 6, **caractérisé en ce que,** pour l'adaptation dans la commande ou dans la régulation, une puissance continue maximale (46) et/ou une capacité de surcharge dynamique (47) de la machine électrique (20) sont modifiées.

8. Procédé selon l'une des revendications précédentes, **caractérisé en ce que** les courants de phase (i-x) et les évolutions temporelles des courants de phase sont détectés à haute fréquence pendant une durée d'états de tension actifs (17).

9. Procédé selon l'une des revendications 1 à 7, **caractérisé en ce que** les courants de phase (i-x) sont détectés pendant des états de tension nulle (18) et une évolution des courants de phase (i-x) pendant les états de tension actifs (17) est reconstruite à partir des courants de phase (i-x) détectés pendant les états de tension nulle (18).

10. Procédé selon l'une des revendications précédentes, **caractérisé en ce que** la position de rotor (14) est estimée dans le cadre d'une régulation sans codeur de la machine électrique (20).

11. Procédé selon la revendication 10, **caractérisé en ce qu'**une estimation de position de rotor de la régulation sans codeur est désactivée lorsqu'une demande de couple à la machine électrique (20) est inférieure à une valeur seuil et/ou est nulle, dans lequel une position de rotor (14) est extrapolée après la désactivation à partir de positions de rotor (14) estimées jusqu'à présent, dans lequel la résistance de phase (40) est déterminée pendant que l'estimation de position de rotor est désactivée, et dans lequel l'estimation de position de rotor est réactivée après la détermination de la résistance de phase (40).

12. Dispositif (1) de détermination d'une résistance de phase (40) d'une machine électrique (20), comprenant un dispositif de commande (2), dans lequel le dispositif de commande (2) est conçu pour recevoir des courants de phase (i-x) détectés à haute fréquence, pour déterminer des tensions de phase (u-x) associées en tenant compte d'une compensation de temps mort, pour recevoir une position de rotor (14) détectée ou estimée de la machine électrique (20), pour commander un onduleur à impulsions (10) alimentant la machine électrique (20) de telle manière, que celui-ci génère et applique par modulation un signal de test à haute fréquence (30) concernant les tensions de phase (u-x), pour déterminer par le biais d'un observateur (5) une composante de tension ohmique-inductive d'une réponse système de la machine électrique (20) au signal de test à haute fréquence (30) appliqué, et pour déterminer et mettre à disposition la résistance de phase (40) à partir de la composante de tension ohmique-inductive déterminée.

**Fig. 1**

**Fig. 2**

Fig. 3

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- DE 102017117725 A1

- US 20210021221 A1

### In der Beschreibung aufgeführte Nicht-Patentliteratur

- **B. WEBER** ; **T. BRANDT** ; **A. MERTENS**. Compensation of switching dead-time effects in voltage-fed PWM inverters using FPGA-based current oversampling. *2016 IEEE Applied Power Electronics Conference and Exposition (APEC)*, 2016, 3172-3179

- Positionsgeberlose Regelung von permanentmagneterregten Synchronmaschinen bei kleinen Drehzahlen mit überabtastender Stromerfassung. **AUS BASTIAN WEBER**. Dissertation. Gottfried Wilhelm Leibniz Universität Hannover, 2018, 163
- Positionsgeberlose Regelung von permanentmagneterregten Synchronmaschinen bei kleinen Drehzahlen mit überabtastender Stromerfassung. **BASTIAN WEBER**. Dissertation. Gottfried Wilhelm Leibniz Universität Hannover, 2018, 163